(19) Europäisches Patentamt
European Patent Office
Office européen des brevets

(11) **EP 4 530 720 A2**

(12) **EUROPÄISCHE PATENTANMELDUNG**

(43) Veröffentlichungstag:
   **02.04.2025 Patentblatt 2025/14**

(21) Anmeldenummer: **24199439.1**

(22) Anmeldetag: **10.09.2024**

(51) Internationale Patentklassifikation (IPC):
   *G03F 7/00* (2006.01)   *G02B 26/08* (2006.01)

(52) Gemeinsame Patentklassifikation (CPC):
   **G03F 7/70266; G02B 26/08**

(84) Benannte Vertragsstaaten:
   **AL AT BE BG CH CY CZ DE DK EE ES FI FR GB GR HR HU IE IS IT LI LT LU LV MC ME MK MT NL NO PL PT RO RS SE SI SK SM TR**
   Benannte Erstreckungsstaaten:
   **BA**
   Benannte Validierungsstaaten:
   **GE KH MA MD TN**

(30) Priorität: **28.09.2023 DE 102023209509**

(71) Anmelder: **Carl Zeiss SMT GmbH**
   **73447 Oberkochen (DE)**

(72) Erfinder: **RICHT, Cornelius**
   **73447 Oberkochen (DE)**

(74) Vertreter: **Horn Kleimann Waitzhofer Schmid-Dreyer**
   **Patent- und Rechtsanwälte PartG mbB**
   **Theresienhöhe 12**
   **80339 München (DE)**

(54) **VERFAHREN ZUM BETREIBEN EINER ANSTEUERVORRICHTUNG, ANSTEUERVORRICHTUNG, OPTISCHES SYSTEM UND LITHOGRAPHIEANLAGE**

(57)   Ein Verfahren zum Betreiben einer Ansteuervorrichtung (100) zum Ansteuern und zum Vermessen einer Mehrzahl N von Aktuatoren (201-225) zum Aktuieren zumindest eines optischen Elements (310) eines optischen Systems (300), wobei während eines bestimmten Vermessungszeitraums ein einzelner zu vermessender Aktuator (201) der N Aktuatoren (201-225) vermessen wird, in dem der zu vermessende Aktuator (201) mittels einer von einer Ansteuereinheit (110) bereitgestellten Anregungsspannung (UA) angeregt wird (S1), ein für einen zeitabhängigen Strom (IA) des mittels der Anregungsspannung (UA) angeregten Aktuators (201) indikativer Messstrom (IM) durch eine Strommesseinheit (120) bereitgestellt wird (S2), eine für eine zeitabhängige Spannung des mittels der Anregungsspannung (UA) angeregten Aktuators (201) indikative Messspannung (UM) durch eine Spannungsmesseinheit (130) bereitgestellt wird (S3), ein Impedanz-Messergebnis (M) basierend auf dem bereitgestellten Messstrom (IM) und der bereitgestellten Messspannung (UM) ermittelt wird (S4) und eine für einen Fehler (F) in der Ansteuervorrichtung (100) indikative Abweichung basierend auf dem ermittelten Impedanz-Messergebnis (M) bestimmt wird (S5), wobei die N-1 weiteren Aktuatoren (202-225) der N Aktuatoren (201-225) auf einem bestimmten Spannungslevel gehalten werden, während der zu vermessende Aktuator (201) mittels der Anregungsspannung (UA) angeregt wird.

Fig. 3

EP 4 530 720 A2

**Beschreibung**

Die vorliegende Erfindung betrifft ein Verfahren zum Betreiben einer Ansteuervorrichtung zum Ansteuern und zum Vermessen einer Mehrzahl von Aktuatoren zum Aktuieren zumindest eines optischen Elements eines optischen Systems, eine Ansteuervorrichtung zum Ansteuern und zum Vermessen einer Mehrzahl von Aktuatoren zum Aktuieren zumindest eines optischen Elements eines optischen Systems, ein optisches System mit einer solchen Ansteuervorrichtung und eine Lithographieanlage mit einem solchen optischen System.

Der Inhalt der Prioritätsanmeldung DE 10 2023 209 509.2 wird durch Bezugnahme vollumfänglich mit einbezogen (incorporation by reference).

Es sind Mikrolithographieanlagen bekannt, die aktuierbare optische Elemente, wie beispielsweise Mikrolinsenarrays oder Mikrospiegelarrays aufweisen. Die Mikrolithographie wird zur Herstellung mikrostrukturierter Bauelemente, wie beispielsweise integrierter Schaltkreise, angewendet. Der Mikrolithographieprozess wird mit einer Lithographieanlage durchgeführt, welche ein Beleuchtungssystem und ein Projektionssystem aufweist.

Getrieben durch das Streben nach immer kleineren Strukturen bei der Herstellung integrierter Schaltungen werden derzeit EUV-Lithographieanlagen entwickelt, welche Licht mit einer Wellenlänge im Bereich von 0,1 nm bis 30 nm, ins-besondere 13,5 nm, verwenden. Da die meisten Materialien Licht dieser Wellen-länge absorbieren, müssen bei solchen EUV-Lithographieanlagen reflektierende Optiken, das heißt Spiegel, anstelle von - wie bisher - brechenden Optiken, das heißt Linsen, eingesetzt werden.

Das Bild einer mittels des Beleuchtungssystems beleuchteten Maske (Retikel) wird hierbei mittels des Projektionssystems auf ein mit einer lichtempfindlichen Schicht (Photoresist) beschichtetes und in der Bildebene des Projektionssystems angeordnetes Substrat, beispielsweise einen Siliziumwafer, projiziert, um die Maskenstruktur auf die lichtempfindliche Beschichtung des Substrats zu übertragen. Mit aktuierbaren optischen Elementen lässt sich die Abbildung der Maske auf dem Substrat verbessern. Beispielsweise lassen sich Wellenfrontfehler bei der Belichtung, die zu vergrößerten und/oder unscharfen Abbildungen führen, ausgleichen.

Für eine solche Korrektur mittels des optischen Elements bedarf es einer Erfassung der Wellenfront und einer Signalverarbeitung zum Ermitteln einer jeweili-gen Position eines optischen Elements, durch welche sich die Wellenfront wie gewünscht korrigieren lässt. Im letzten Schritt wird das Ansteuersignal für ein je-weiliges optisches Element verstärkt und an den Aktuator des optischen Elements ausgegeben werden.

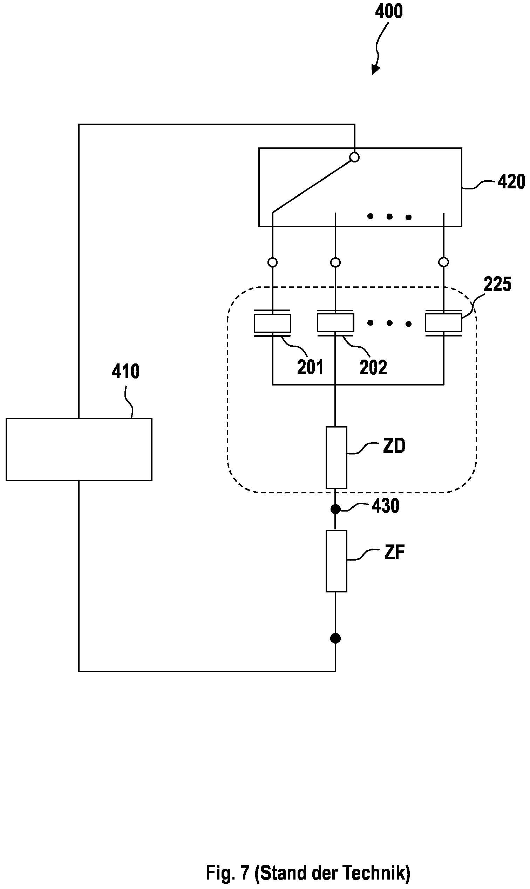

Als Aktuator kann beispielsweise ein PMN-Aktuator (PMN; Blei-Magnesium-Niobate) eingesetzt werden. Ein PMN-Aktuator ermöglicht eine Streckenpositio-nierung im Sub-Mikrometer-Bereich oder Sub-Nanometer-Bereich. Dabei erfährt der Aktuator, dessen Aktuator-Elemente aufeinandergestapelt sind, durch Anle-gen einer Gleichspannung eine Kraft, welche eine bestimmte Längenausdehnung verursacht. Die durch die Gleichspannung oder DC-Spannung (DC; Direct Cur-rent) eingestellte Position kann durch ein externes elektromechanisches Über-sprechen an den sich prinzipbedingt ergebenden Resonanzstellen des mit der Gleichspannung angesteuerten Aktuators negativ beeinflusst werden. In Folge dieses elektromechanischen Übersprechens ist eine präzise Positionierung nicht mehr stabil einstellbar. Dabei sind die mechanischen Resonanzen umso stärker, je höher die angelegte Gleichspannung ist. Diese Resonanzstellen können sich auch langfristig, zum Beispiel durch Temperaturdrift oder durch Klebedrift, wenn sich die mechanische Anbindung des Klebematerials ändert, oder durch Hysterese oder Alterung ändern. Beispielsweise in diesem Zusammenhang ist eine Impedanzmessung hilfreich. Herkömmliche Lösungen zur Impedanzmessung einer Mehrzahl von Aktuatoren eines optischen Systems führen eine Impedanzmessung der einzelnen Aktuatoren nacheinander durch. Hierzu zeigt die Fig. 7 ein schematisches Blockdiagramm einer solchen herkömmlichen Ansteuervorrichtung 400 zum Vermessen einer Mehrzahl N von Aktuatoren 201-225 zum Aktuieren zumindest eines optischen Elements eines optischen Systems. Beispielsweise ist N gleich 25 (N=25).

Wie die Fig. 7 zeigt, hat die Ansteuervorrichtung 400 eine Ansteuereinheit 410 und eine Schaltmatrix 420. Außerdem bezeichnet ZD die Impedanz eines möglichen Defektes in der Ansteuervorrichtung 400 zwischen dem Ausgang der Aktuatoren 201-225 und einer gemeinsamen negativen Elektrode 430, und ZZ bezeichnet die Impedanz der Zuleitung, welche die gemeinsame Elektrode 430 mit einer Strommesseinheit (nicht dargestellt) verbindet. Hierbei ist die Schaltmatrix 420 dazu eingerichtet, nur den zu vermessenden Aktuator, in dem Beispiel der Fig. 7 der Aktuator 201, mit der Ansteuereinheit 410 zu verbinden. Wenn der Aktuator 201 vermessen ist, kann die Schaltmatrix 420 den nächsten Aktuator 202 mit der Ansteuereinheit 410 verbinden. Somit stellt die Schaltmatrix 420 der Fig. 7 sicher, dass immer nur ein einzelner Aktuator, beispielsweise der Aktuator 201, mit der Ansteuereinheit 410 verbunden ist und die übrigen Aktuatoren 202-225 nicht kontaktiert sind. Bei der Impedanz-Messung werden dann die Impedanz der Zuleitung ZZ und die Impedanz ZD eines möglichen Defektes in der Ansteuervorrichtung 400 mit dem Faktor 1 sichtbar. Änderungen werden damit nicht verstärkt.

Bei der Vermessung der einzelnen Aktuatoren 202-225 nacheinander ist erforderlich, die weiteren N-1 Aktuatoren abzuklemmen. Folglich ist das Vermessen der Aktuatoren 201-225 gemäß Fig. 7 nicht im laufenden Betrieb des optischen Systems möglich. Auch ist die Detektion von Schaltungsdefekten an der gemeinsamen Masse-Leitung wegen geringer Impedanz nur bei größeren Defekten detektierbar.

Vor diesem Hintergrund besteht eine Aufgabe der vorliegenden Erfindung darin, die Vermessung eines Aktuators eines optischen Systems zu verbessern.

Gemäß einem ersten Aspekt wird ein Verfahren zum Betreiben einer Ansteuervorrichtung zum Ansteuern und zum Vermessen einer Mehrzahl N von Aktuatoren zum Aktuieren zumindest eines optischen Elements eines optischen Systems vorgeschlagen. Dabei wird während eines bestimmten Vermessungszeitraums ein einzelner zu vermessender Aktuator der N Aktuatoren vermessen, in dem der zu vermessende Aktuator mittels einer von einer Ansteuereinheit bereitgestellten Anregungsspannung angeregt wird, ein für einen zeitabhängigen Strom des mittels der Anregungsspannung angeregten Aktuators indikativer Messstrom durch eine Strommesseinheit bereitgestellt wird, eine für eine zeitabhängige Spannung des mittels der Anregungsspannung angeregten Aktuators indikative Messspannung durch eine Spannungsmesseinheit bereitgestellt wird, ein Impedanz-Messergebnis basierend auf dem bereitgestellten Messstrom und der bereitgestellten Messspannung ermittelt wird und eine für einen Fehler in der Ansteuervorrichtung indikative Abweichung basierend auf dem ermittelten Impedanz-Messergebnis bestimmt wird, wobei die N-1 weiteren Aktuatoren der N Aktuatoren auf einem bestimmten Spannungslevel gehalten werden, während der zu vermessende Aktuator mittels der Anregungsspannung angeregt wird.

Dadurch, dass die N-1 weiteren Aktuatoren auf einem bestimmten Spannungslevel gehalten werden, während der zu vermessende Aktuator vermessen wird, kann ein Teil des Anregungsstroms als Fehlerstrom in die N-1 weiteren Aktuatoren abfließen. Dies verfälscht die Impedanz-Messung des zu vermessenden Aktuators und macht sie um den Faktor N-1 sensitiver auf eine Änderung, zum Beispiel in der Zuleitungsimpedanz der Zuleitung zu der Strommesseinheit.

Dadurch, dass die vorliegende Impedanz-Messung deutlich sensitiver ist, können Fehler bei geringerer Impedanz und insbesondere mit höherer Sicherheit detektiert werden. Im Detail ist durch die höhere Sensitivität der vorliegenden Impedanz-Messung die Detektion von Schaltungsdefekten an der gemeinsamen Masse-Leitung der N Aktuatoren auch schon bei kleineren Defekten detektierbar. Der Effekt eines Defekts auf der gemeinsamen Masse-Leitung verstärkt sich vorliegend um den Faktor N-1. Dadurch ist auch bereits bei geringen Störungen eine Detektion möglich.

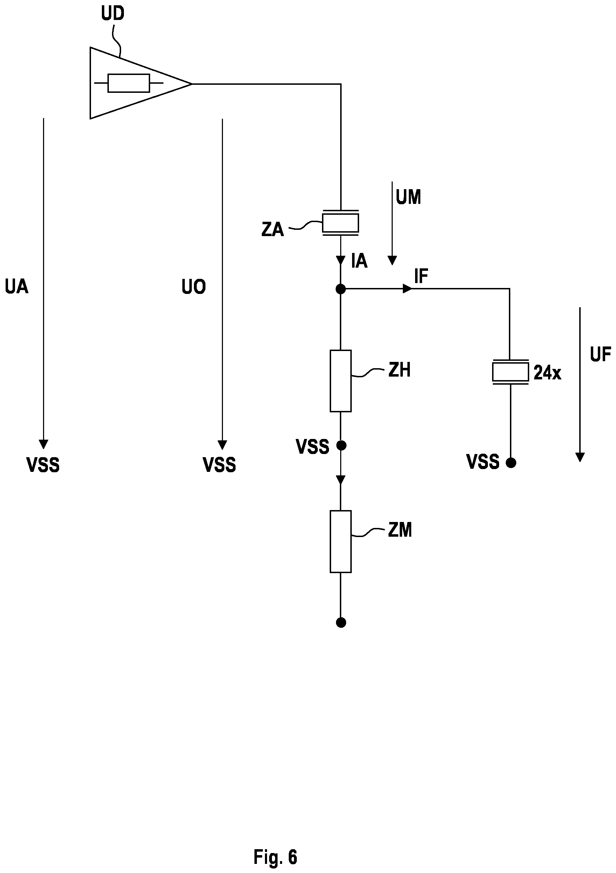

Beispielsweise ist N = 25. In diesem Fall ist die vorliegende Impedanz-Messung 24-fach sensitiver als bei einer herkömmlichen Impedanz-Messung, wie sie beispielsweise in Fig. 7 dargestellt ist. Das unten dargestellte Beispiel der Fig. 6 illustriert an einem Kleinsignal-Ersatzschaltbild für das Beispiel N = 25, dass die vorliegende Impedanz-Messung um den Faktor 24 sensitiver ist.

Basierend auf dem ermittelten Impedanz-Messergebnis des Aktuators bzw. basierend auf der bestimmten Abweichung können geeignete Abhilfen oder Gegenmaßnahmen, insbesondere eine aktive Inline-Kalibrierung oder Inline-Dämpfung, ergriffen werden. Die vorliegende Impedanz-Messung dient insbesondere zu Health-Monitoring-Zwecken, dabei insbesondere zur Sicherstellung der Signalübertragungsqualität bei Verbindungsübergängen.

Der Aktuator ist insbesondere ein kapazitiver Aktuator, beispielsweise ein PMN-Aktuator (PMN; Blei-Magnesium-Niobate) oder ein PZT-Aktuator (PZT; Blei-Zirkonat-Titanate) oder ein LiNbO3-Aktuator (Lithiumniobat). Der Aktuator ist insbesondere dazu eingerichtet, ein optisches Element des optischen Systems zu aktuieren. Beispiele für ein solches optisches Element umfassen Linsen, Spiegel und adaptive Spiegel.

Das optische System ist bevorzugt eine Projektionsoptik der Lithographieanlage oder Projektionsbelichtungsanlage. Das optische System kann jedoch auch ein Beleuchtungssystem sein. Die Projektionsbelichtungsanlage kann eine EUV-Lithographieanlage sein. EUV steht für "Extreme Ultraviolet" und bezeichnet eine Wellenlänge des Arbeitslichts zwischen 0,1 nm und 30 nm. Die Projektionsbelichtungsanlage kann auch eine DUV-Lithographieanlage sein. DUV steht für "Deep Ultraviolet" und bezeichnet eine Wellenlänge des Arbeitslichts zwischen 30 nm und 250 nm.

Gemäß einer Ausführungsform wird das Vermessen des zu vermessenden Aktuators im laufenden Betrieb des optischen Systems durchgeführt. Ein Vorteil liegt hier darin, dass das optische System nicht extra in einen Diagnose-Modus versetzt werden müsste, um die Impedanz-Messung an dem zu vermessenden Aktuator durchzuführen. Vielmehr wird vorliegend die Impedanz-Messung im laufenden Betrieb des optischen Systems durchgeführt.

Gemäß einer weiteren Ausführungsform werden die N-1 weiteren Aktuatoren auf einer bestimmten Haltespannung gehalten, während der zu vermessende Aktuator mittels der Anregungsspannung angeregt wird.

Gemäß einer weiteren Ausführungsform sind die bestimmten Haltespannungen der N-1 weiteren Aktuatoren identisch. Die Haltespannung kann auch als Bias-Spannung bezeichnet werden.

Gemäß einer weiteren Ausführungsform werden die N-1 weiteren Aktuatoren kurzgeschlossen, während der zu vermessende Aktuator mittels der Anregungsspannung angeregt wird.

Gemäß einer weiteren Ausführungsform werden die N Aktuatoren an einer gemeinsamen negativen Elektrode verbunden. Durch die vorliegende Impedanz-Messung kann die korrekte Funktion der gemeinsamen negativen Elektrode im Betrieb des optischen Systems ermittelt werden, wodurch Ausfälle vorteilhafterweise vermieden werden können.

Gemäß einer weiteren Ausführungsform wird die Strommesseinheit zum Bereitstellen des Messstroms, welcher indikativ für den zeitabhängigen Strom des mittels der Anregungsspannung angeregten Aktuators ist, zwischen der negativen Elektrode der N Aktuatoren und den N Ansteuereinheiten für die N Aktuatoren gekoppelt.

Gemäß einer weiteren Ausführungsform wird die Spannungsmesseinheit zum Bereitstellen der Messspannung parallel zu dem zu vermessenden Aktuator geschaltet.

Gemäß einer weiteren Ausführungsform wird die Spannungsmesseinheit zum Bereitstellen der Messspannung mit der dem zu vermessenden Aktuator zugeordneten Ansteuereinheit gekoppelt. In diesem Fall wird die Messspannung zur Ermittlung des Impedanz-Messergebnisses vorzugsweise aus der Anregungsspannung abgeleitet.

Gemäß einer weiteren Ausführungsform sind die N Aktuatoren und die gemeinsame negativen Elektrode als Teil einer Aktuatormatte ausgebildet.

Gemäß einer weiteren Ausführungsform umfasst die Ansteuereinheit eine Verstärkerschaltung, insbesondere einen Differenzverstärker.

Gemäß einem zweiten Aspekt wird eine Ansteuervorrichtung zum Ansteuern und zum Vermessen einer Mehrzahl N von Aktuatoren zum Aktuieren zumindest eines optischen Elements eines optischen Systems vorgeschlagen. Die Ansteuervorrichtung umfasst eine Steuereinheit, welche dazu eingerichtet ist, ein Vermessen eines einzelnen zu vermessenden Aktuators der N Aktuatoren während eines bestimmten Vermessungszeitraums zu steuern, eine von der Steuereinheit gesteuerte Ansteuereinheit, welche dazu eingerichtet ist, den zu vermessenden Aktuator mittels einer Anregungsspannung anzuregen, eine Strommesseinheit zum Bereitstellen eines für einen zeitabhängigen Strom des mittels der Anregungsspannung angeregten Aktuators indikativen Messstroms, und eine Spannungsmesseinheit zum Bereitstellen einer für eine zeitabhängige Spannung des mittels der Anregungsspannung angeregten Aktuators indikativen Messspannung. Hierbei ist die Steuereinheit dazu eingerichtet zu steuern, dass die N-1 weiteren Aktuatoren der N Aktuatoren auf einem bestimmten Spannungslevel gehalten werden, während der zu vermessende Aktuator mittels der Anregungsspannung angeregt wird. Ferner ist die Steuereinheit dazu eingerichtet, ein Impedanz-Messergebnis basierend auf dem bereitgestellten Messstrom und der bereitgestellten Messspannung zu ermitteln und eine für einen Fehler in der Ansteuervorrichtung indikative Abweichung basierend auf dem ermittelten Impedanz-Messergebnis zu bestimmen.

Vorzugsweise sind die N Aktuatoren an einer gemeinsamen negativen Elektrode verbunden.

Die für das vorgeschlagene Verfahren beschriebenen Ausführungsformen gelten für die vorgeschlagene Ansteuervorrichtung entsprechend und umgekehrt. Weiterhin gelten die Definitionen und Erläuterungen zu dem Verfahren auch für die vorgeschlagene Ansteuervorrichtung entsprechend.

Die jeweilige Einheit, zum Beispiel die Steuereinheit, kann hardwaretechnisch und/oder auch softwaretechnisch implementiert sein. Bei einer hardware-technischen Implementierung kann die Einheit als Vorrichtung oder als Teil einer Vorrichtung, zum Beispiel als Computer oder als Mikroprozessor oder als Teil der Steuervorrichtung ausgebildet sein. Bei einer softwaretechnischen Implementierung kann die Einheit als Computerprogrammprodukt, als eine Funktion, als eine Routine, als Teil eines Programmcodes oder als ausführbares Objekt ausgebildet sein.

Gemäß einem dritten Aspekt wird ein optisches System mit einer Anzahl an aktuierbaren optischen Elementen vorgeschlagen, wobei jedem der aktuierbaren optischen Elemente eine Anzahl an Aktuatoren zugeordnet ist, welchen eine Ansteuervorrichtung zum Ansteuern der Aktuatoren gemäß dem zweiten Aspekt oder gemäß einer der Ausführungsformen des zweiten Aspekts zugeordnet ist.

Das optische System umfasst insbesondere ein Mikrospiegelarray und/oder ein Mikrolinsenarray mit einer Vielzahl an unabhängig voneinander aktuierbaren optischen Elementen.

In Ausführungsformen lassen sich Gruppen von Aktuatoren definieren, wobei allen Aktuatoren einer Gruppe die gleiche Ansteuervorrichtung zugeordnet sind.

Gemäß einer Ausführungsform ist das optische System als eine Beleuchtungsoptik oder als eine Projektionsoptik einer Lithographieanlage ausgebildet.

Gemäß einer weiteren Ausführungsform weist das optische System ein Vakuumgehäuse auf, in welchem die aktuierbaren optischen Elemente, die zugeordneten Aktuatoren und die Ansteuervorrichtung angeordnet sind.

Gemäß einem vierten Aspekt wird eine Lithographieanlage vorgeschlagen, welche ein optisches System gemäß dem dritten Aspekt oder gemäß einer der Ausführungsformen des dritten Aspekts aufweist.

Die Lithographieanlage ist beispielsweise eine EUV-Lithographieanlage, deren Arbeitslicht in einem Wellenlängenbereich von 0,1 nm bis 30 nm liegt, oder eine DUV-Lithographieanlage, deren Arbeitslicht in einem Wellenlängenbereich von 30 nm bis 250 nm liegt.

"Ein" ist vorliegend nicht zwingend als beschränkend auf genau ein Element zu verstehen. Vielmehr können auch mehrere Elemente, wie beispielsweise zwei, drei oder mehr, vorgesehen sein. Auch jedes andere hier verwendete Zählwort ist nicht dahingehend zu verstehen, dass eine Beschränkung auf genau die genannte Anzahl von Elementen gegeben ist. Vielmehr sind zahlenmäßige Abweichungen nach oben und nach unten möglich, soweit nichts Gegenteiliges angegeben ist.

Weitere mögliche Implementierungen der Erfindung umfassen auch nicht explizit genannte Kombinationen von zuvor oder im Folgenden bezüglich der Ausführungsbeispiele beschriebenen Merkmalen oder Ausführungsformen. Dabei wird der Fachmann auch Einzelaspekte als Verbesserungen oder Ergänzungen zu der jeweiligen Grundform der Erfindung hinzufügen.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.

Fig. 1 zeigt einen schematischen Meridionalschnitt einer Projektionsbelichtungsanlage für eine EUV-Projektionslithographie;

Fig. 2 zeigt eine schematische Darstellung einer Ausführungsform eines optischen Systems;

Fig. 3 zeigt eine schematische Ansicht einer Ausführungsform eines Verfahrens zum Ansteuern und zum Vermessen einer Mehrzahl von Aktuatoren zum Aktuieren zumindest eines optischen Elements eines optischen Systems,

Fig. 4 zeigt ein schematisches Blockdiagramm einer ersten Ausführungsform einer Ansteuervorrichtung zum Ansteuern und zum Vermessen einer Mehrzahl von Aktuatoren zum Aktuieren zumindest eines optischen Elements eines optischen Systems,

Fig. 5 zeigt ein schematisches Blockdiagramm einer zweiten Ausführungsform einer Ansteuervorrichtung zum Ansteuern und zum Vermessen einer Mehrzahl von Aktuatoren zum Aktuieren zumindest eines optischen Elements eines optischen Systems,

Fig. 6 zeigt ein Kleinsignal-Ersatzschaltbild einer Ausführungsform einer Ansteuervorrichtung zum Ansteuern und zum Vermessen einer Mehrzahl von Aktuatoren zum Aktuieren zumindest eines optischen Elements eines optischen Systems, und

Fig. 7 zeigt ein schematisches Blockdiagramm einer herkömmlichen Ansteuervorrichtung zum Vermessen einer Mehrzahl von Aktuatoren zum Aktuieren zumindest eines optischen Elements eines optischen Systems.

In den Figuren sind gleiche oder funktionsgleiche Elemente mit denselben Bezugszeichen versehen worden, soweit nichts Gegenteiliges angegeben ist. Ferner sollte beachtet werden, dass die Darstellungen in den Figuren nicht notwendigerweise maßstabsgerecht sind.

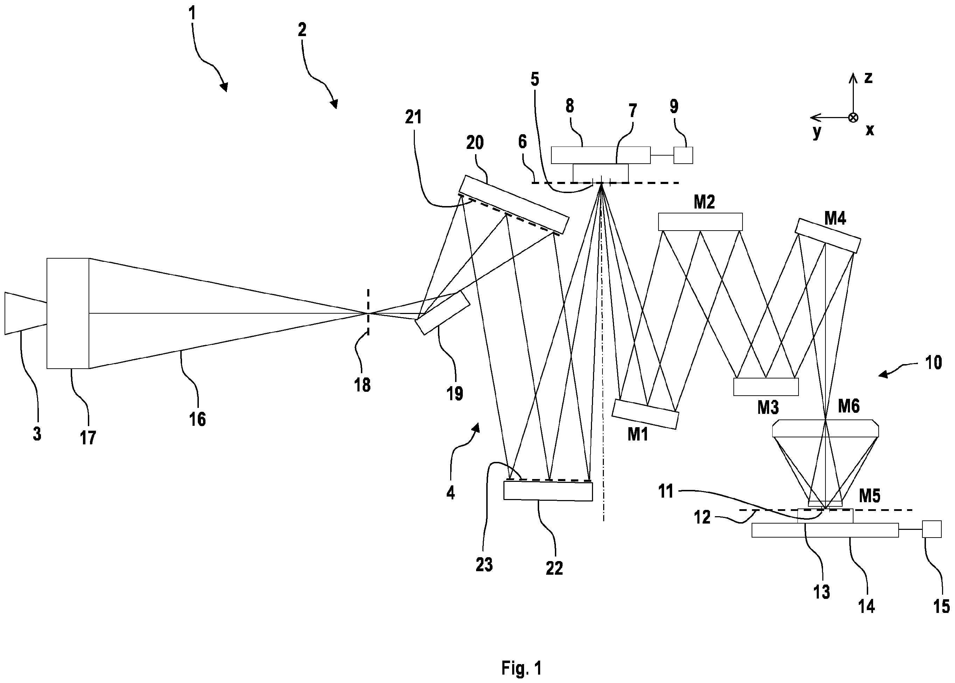

Fig. 1 zeigt eine Ausführungsform einer Projektionsbelichtungsanlage 1 (Lithographieanlage), insbesondere einer EUV-Lithographieanlage. Eine Ausführung eines Beleuchtungssystems 2 der Projektionsbelichtungsanlage 1 hat neben einer Lichtbeziehungsweise Strahlungsquelle 3 eine Beleuchtungsoptik 4 zur Beleuchtung eines Objektfeldes 5 in einer Objektebene 6. Bei einer alternativen Ausführung kann die Lichtquelle 3 auch als ein zum sonstigen Beleuchtungssystem 2 separates Modul bereitgestellt sein. In diesem Fall umfasst das Beleuchtungssystem 2 die Lichtquelle 3 nicht.

Belichtet wird ein im Objektfeld 5 angeordnetes Retikel 7. Das Retikel 7 ist von einem Retikelhalter 8 gehalten. Der Retikelhalter 8 ist über einen Retikelverlagerungsantrieb 9, insbesondere in einer Scanrichtung, verlagerbar.

In der Fig. 1 ist zur Erläuterung ein kartesisches Koordinatensystem mit einer x-Richtung x, einer y-Richtung y und einer z-Richtung z eingezeichnet. Die x-Richtung x verläuft senkrecht in die Zeichenebene hinein. Die y-Richtung y verläuft horizontal und die z-Richtung z verläuft vertikal. Die Scanrichtung verläuft in der Fig. 1 längs der y-Richtung y. Die z-Richtung z verläuft senkrecht zur Objektebene 6.

Die Projektionsbelichtungsanlage 1 umfasst eine Projektionsoptik 10. Die Projektionsoptik 10 dient zur Abbildung des Objektfeldes 5 in ein Bildfeld 11 in einer Bildebene 12. Die Bildebene 12 verläuft parallel zur Objektebene 6. Alternativ ist auch ein von 0° verschiedener Winkel zwischen der Objektebene 6 und der Bildebene 12 möglich.

Abgebildet wird eine Struktur auf dem Retikel 7 auf eine lichtempfindliche Schicht eines im Bereich des Bildfeldes 11 in der Bildebene 12 angeordneten Wafers 13. Der Wafer 13 wird von einem Waferhalter 14 gehalten. Der Waferhalter 14 ist über einen Waferverlagerungsantrieb 15 insbesondere längs der y-Richtung y verlagerbar.

Die Verlagerung einerseits des Retikels 7 über den Retikelverlagerungsantrieb 9 und andererseits des Wafers 13 über den Waferverlagerungsantrieb 15 kann synchronisiert zueinander erfolgen.

Bei der Lichtquelle 3 handelt es sich um eine EUV-Strahlungsquelle. Die Lichtquelle 3 emittiert insbesondere EUV-Strahlung 16, welche im Folgenden auch als Nutzstrahlung, Beleuchtungsstrahlung oder Beleuchtungslicht bezeichnet wird. Die Nutzstrahlung 16 hat insbesondere eine Wellenlänge im Bereich zwischen 5 nm und 30 nm. Bei der Lichtquelle 3 kann es sich um eine Plasmaquelle handeln, zum Beispiel um eine LPP-Quelle (Engl.: Laser Produced Plasma, mit Hilfe eines Lasers erzeugtes Plasma) oder um eine DPP-Quelle (Engl.: Gas Discharged Produced Plasma, mittels Gasentladung erzeugtes Plasma). Es kann sich auch um eine synchrotronbasierte Strahlungsquelle handeln. Bei der Lichtquelle 3 kann es sich um einen Freie-Elektronen-Laser (Engl.: Free-Electron-Laser, FEL) handeln.

Die Beleuchtungsstrahlung 16, die von der Lichtquelle 3 ausgeht, wird von einem Kollektor 17 gebündelt. Bei dem Kollektor 17 kann es sich um einen Kollektor mit einer oder mit mehreren ellipsoidalen und/oder hyperboloiden Reflexionsflächen handeln. Die mindestens eine Reflexionsfläche des Kollektors 17 kann im streifenden Einfall (Engl.: Grazing Incidence, GI), also mit Einfallswinkeln größer als 45°, oder im normalen Einfall (Engl.: Normal Incidence, NI), also mit Einfallwinkeln kleiner als 45°, mit der Beleuchtungsstrahlung 16 beaufschlagt werden. Der Kollektor 17 kann einerseits zur Optimierung seiner Reflektivität für die Nutzstrahlung und andererseits zur Unterdrückung von Falschlicht strukturiert und/oder beschichtet sein.

Nach dem Kollektor 17 propagiert die Beleuchtungsstrahlung 16 durch einen Zwischenfokus in einer Zwischenfokusebene 18. Die Zwischenfokusebene 18 kann eine Trennung zwischen einem Strahlungsquellenmodul, aufweisend die Lichtquelle 3 und den Kollektor 17, und der Beleuchtungsoptik 4 darstellen.

Die Beleuchtungsoptik 4 umfasst einen Umlenkspiegel 19 und diesem im Strahlengang nachgeordnet einen ersten Facettenspiegel 20. Bei dem Umlenkspiegel 19 kann es sich um einen planen Umlenkspiegel oder alternativ um einen Spiegel mit einer über die reine Umlenkungswirkung hinaus bündelbeeinflussenden Wirkung handeln. Alternativ oder zusätzlich kann der Umlenkspiegel 19 als Spektralfilter ausgeführt sein, der eine Nutzlichtwellenlänge der Beleuchtungsstrahlung 16 von Falschlicht einer hiervon abweichenden Wellenlänge trennt. Sofern der erste Facettenspiegel 20 in einer Ebene der Beleuchtungsoptik 4 angeordnet ist, die zur Objektebene 6 als Feldebene optisch konjugiert ist, wird dieser auch als Feldfacettenspiegel bezeichnet. Der erste Facettenspiegel 20 umfasst eine Vielzahl von einzelnen ersten Facetten 21, welche auch als Feldfacetten bezeichnet werden können. Von diesen ersten Facetten 21 sind in der Fig. 1 nur beispielhaft einige dargestellt.

Die ersten Facetten 21 können als makroskopische Facetten ausgeführt sein, insbesondere als rechteckige Facetten oder als Facetten mit bogenförmiger oder teilkreisförmiger Randkontur. Die ersten Facetten 21 können als plane Facetten oder alternativ als konvex oder konkav gekrümmte Facetten ausgeführt sein.

Wie beispielsweise aus der DE 10 2008 009 600 A1 bekannt ist, können die ersten Facetten 21 selbst jeweils auch aus einer Vielzahl von Einzelspiegeln, insbesondere einer Vielzahl von Mikrospiegeln, zusammengesetzt sein. Der erste Facettenspiegel 20 kann insbesondere als mikroelektromechanisches System (MEMS-System) ausgebildet sein. Für Details wird auf die DE 10 2008 009 600 A1 verwiesen.

Zwischen dem Kollektor 17 und dem Umlenkspiegel 19 verläuft die Beleuchtungsstrahlung 16 horizontal, also längs der y-Richtung y.

Im Strahlengang der Beleuchtungsoptik 4 ist dem ersten Facettenspiegel 20 nachgeordnet ein zweiter Facettenspiegel 22. Sofern der zweite Facettenspiegel 22 in einer Pupillenebene der Beleuchtungsoptik 4 angeordnet ist, wird dieser auch als Pupillenfacettenspiegel bezeichnet. Der zweite Facettenspiegel 22 kann auch beabstandet zu einer Pupillenebene der Beleuchtungsoptik 4 angeordnet sein. In diesem Fall wird die Kombination aus dem ersten Facettenspiegel 20 und dem zweiten Facettenspiegel 22 auch als spekularer Reflektor bezeichnet. Spekulare Reflektoren sind bekannt aus der US 2006/0132747 A1, der EP 1 614 008 B1 und der US 6,573,978.

Der zweite Facettenspiegel 22 umfasst eine Mehrzahl von zweiten Facetten 23. Die zweiten Facetten 23 werden im Falle eines Pupillenfacettenspiegels auch als Pupillenfacetten bezeichnet.

Bei den zweiten Facetten 23 kann es sich ebenfalls um makroskopische Facetten, die beispielsweise rund, rechteckig oder auch hexagonal berandet sein können, oder alternativ um aus Mikrospiegeln zusammengesetzte Facetten handeln. Diesbezüglich wird ebenfalls auf die DE 10 2008 009 600 A1 verwiesen.

Die zweiten Facetten 23 können plane oder alternativ konvex oder konkav gekrümmte Reflexionsflächen aufweisen.

Die Beleuchtungsoptik 4 bildet somit ein doppelt facettiertes System. Dieses grundlegende Prinzip wird auch als Wabenkondensor (Engl.: Fly's Eye Integrator) bezeichnet.

Es kann vorteilhaft sein, den zweiten Facettenspiegel 22 nicht exakt in einer Ebene, welche zu einer Pupillenebene der Projektionsoptik 10 optisch konjugiert ist, anzuordnen. Insbesondere kann der zweite Facettenspiegel 22 gegenüber einer Pupillenebene der Projektionsoptik 10 verkippt angeordnet sein, wie es zum Beispiel in der DE 10 2017 220 586 A1 beschrieben ist.

Mit Hilfe des zweiten Facettenspiegels 22 werden die einzelnen ersten Facetten 21 in das Objektfeld 5 abgebildet. Der zweite Facettenspiegel 22 ist der letzte bündelformende oder auch tatsächlich der letzte Spiegel für die Beleuchtungsstrahlung 16 im Strahlengang vor dem Objektfeld 5.

Bei einer weiteren, nicht dargestellten Ausführung der Beleuchtungsoptik 4 kann im Strahlengang zwischen dem zweiten Facettenspiegel 22 und dem Objektfeld 5 eine Übertragungsoptik angeordnet sein, die insbesondere zur Abbildung der ersten Facetten 21 in das Objektfeld 5 beiträgt. Die Übertragungsoptik kann genau einen Spiegel, alternativ aber auch zwei oder mehr Spiegel aufweisen, welche hintereinander im Strahlengang der Beleuchtungsoptik 4 angeordnet sind. Die Übertragungsoptik kann insbesondere einen oder zwei Spiegel für senkrechten Einfall (NI-Spiegel, Normal Incidence Spiegel) und/oder einen oder zwei Spiegel für streifenden Einfall (GI-Spiegel, Grazing Incidence Spiegel) umfassen.

Die Beleuchtungsoptik 4 hat bei der Ausführung, die in der Fig. 1 gezeigt ist, nach dem Kollektor 17 genau drei Spiegel, nämlich den Umlenkspiegel 19, den ersten Facettenspiegel 20 und den zweiten Facettenspiegel 22.

Bei einer weiteren Ausführung der Beleuchtungsoptik 4 kann der Umlenkspiegel 19 auch entfallen, so dass die Beleuchtungsoptik 4 nach dem Kollektor 17 dann genau zwei Spiegel aufweisen kann, nämlich den ersten Facettenspiegel 20 und den zweiten Facettenspiegel 22.

Die Abbildung der ersten Facetten 21 mittels der zweiten Facetten 23 beziehungsweise mit den zweiten Facetten 23 und einer Übertragungsoptik in die Objektebene 6 ist regelmäßig nur eine näherungsweise Abbildung.

Die Projektionsoptik 10 umfasst eine Mehrzahl von Spiegeln Mi, welche gemäß ihrer Anordnung im Strahlengang der Projektionsbelichtungsanlage 1 durchnummeriert sind.

Bei dem in der Fig. 1 dargestellten Beispiel umfasst die Projektionsoptik 10 sechs Spiegel M1 bis M6. Alternativen mit vier, acht, zehn, zwölf oder einer anderen Anzahl an Spiegeln Mi sind ebenso möglich. Bei der Projektionsoptik 10 handelt es sich um eine doppelt obskurierte Optik. Der vorletzte Spiegel M5 und der letzte Spiegel M6 haben jeweils eine Durchtrittsöffnung für die Beleuchtungsstrahlung 16. Die Projektionsoptik 10 hat eine bildseitige numerische Apertur, die größer ist als 0,5 und die auch größer sein kann als 0,6 und die beispielsweise 0,7 oder 0,75 betragen kann.

Reflexionsflächen der Spiegel Mi können als Freiformflächen ohne Rotationssymmetrieachse ausgeführt sein. Alternativ können die Reflexionsflächen der Spiegel Mi als asphärische Flächen mit genau einer Rotationssymmetrieachse der Reflexionsflächenform gestaltet sein. Die Spiegel Mi können, genauso wie die Spiegel der Beleuchtungsoptik 4, hochreflektierende Beschichtungen für die Beleuchtungsstrahlung 16 aufweisen. Diese Beschichtungen können als Multilayer-Beschichtungen, insbesondere mit alternierenden Lagen aus Molybdän und Silizium, gestaltet sein.

Die Projektionsoptik 10 hat einen großen Objekt-Bildversatz in der y-Richtung y zwischen einer y-Koordinate eines Zentrums des Objektfeldes 5 und einer y-Koordinate des Zentrums des Bildfeldes 11. Dieser Objekt-Bild-Versatz in der y-Richtung y kann in etwa so groß sein wie ein z-Abstand zwischen der Objektebene 6 und der Bildebene 12.

Die Projektionsoptik 10 kann insbesondere anamorphotisch ausgebildet sein. Sie weist insbesondere unterschiedliche Abbildungsmaßstäbe βx, βy in x- und y-Richtung x, y auf. Die beiden Abbildungsmaßstäbe βx, βy der Projektionsoptik 10 liegen bevorzugt bei (βx, βy) = (+/- 0,25, /+- 0,125). Ein positiver Abbildungsmaßstab 6 bedeutet eine Abbildung ohne Bildumkehr. Ein negatives Vorzeichen für den Abbildungsmaßstab 6 bedeutet eine Abbildung mit Bildumkehr.

Die Projektionsoptik 10 führt somit in x-Richtung x, das heißt in Richtung senkrecht zur Scanrichtung, zu einer Verkleinerung im Verhältnis 4:1.

Die Projektionsoptik 10 führt in y-Richtung y, das heißt in Scanrichtung, zu einer Verkleinerung von 8:1.

Andere Abbildungsmaßstäbe sind ebenso möglich. Auch vorzeichengleiche und absolut gleiche Abbildungsmaßstäbe in x- und y-Richtung x, y, zum Beispiel mit Absolutwerten von 0,125 oder von 0,25, sind möglich.

Die Anzahl von Zwischenbildebenen in der x- und in der y-Richtung x, y im Strahlengang zwischen dem Objektfeld 5 und dem Bildfeld 11 kann gleich sein oder kann, je nach Ausführung der Projektionsoptik 10, unterschiedlich sein. Beispiele für Projektionsoptiken mit unterschiedlichen Anzahlen derartiger Zwischenbilder in x- und y-Richtung x, y sind bekannt aus der US 2018/0074303 A1.

Jeweils eine der zweiten Facetten 23 ist genau einer der ersten Facetten 21 zur Ausbildung jeweils eines Beleuchtungskanals zur Ausleuchtung des Objektfeldes 5 zugeordnet. Es kann sich hierdurch insbesondere eine Beleuchtung nach dem Köhlerschen Prinzip ergeben. Das Fernfeld wird mit Hilfe der ersten Facetten 21 in eine Vielzahl an Objektfeldern 5 zerlegt. Die ersten Facetten 21 erzeugen eine Mehrzahl von Bildern des Zwischenfokus auf den diesen jeweils zugeordneten zweiten Facetten 23.

Die ersten Facetten 21 werden jeweils von einer zugeordneten zweiten Facette 23 einander überlagernd zur Ausleuchtung des Objektfeldes 5 auf das Retikel 7 abgebildet. Die Ausleuchtung des Objektfeldes 5 ist insbesondere möglichst homogen. Sie weist vorzugsweise einen Uniformitätsfehler von weniger als 2 % auf. Die Felduniformität kann über die Überlagerung unterschiedlicher Beleuchtungskanäle erreicht werden.

Durch eine Anordnung der zweiten Facetten 23 kann geometrisch die Ausleuchtung der Eintrittspupille der Projektionsoptik 10 definiert werden. Durch Auswahl der Beleuchtungskanäle, insbesondere der Teilmenge der zweiten Facetten 23, die Licht führen, kann die Intensitätsverteilung in der Eintrittspupille der Projektionsoptik 10 eingestellt werden. Diese Intensitätsverteilung wird auch als Beleuchtungssetting oder Beleuchtungspupillenfüllung bezeichnet.

Eine ebenfalls bevorzugte Pupillenuniformität im Bereich definiert ausgeleuchteter Abschnitte einer Beleuchtungspupille der Beleuchtungsoptik 4 kann durch eine Umverteilung der Beleuchtungskanäle erreicht werden.

Im Folgenden werden weitere Aspekte und Details der Ausleuchtung des Objektfeldes 5 sowie insbesondere der Eintrittspupille der Projektionsoptik 10 beschrieben.

Die Projektionsoptik 10 kann insbesondere eine homozentrische Eintrittspupille aufweisen. Diese kann zugänglich sein. Sie kann auch unzugänglich sein.

Die Eintrittspupille der Projektionsoptik 10 lässt sich regelmäßig mit dem zweiten Facettenspiegel 22 nicht exakt ausleuchten. Bei einer Abbildung der Projektionsoptik 10, welche das Zentrum des zweiten Facettenspiegels 22 telezentrisch auf den Wafer 13 abbildet, schneiden sich die Aperturstrahlen oftmals nicht in einem einzigen Punkt. Es lässt sich jedoch eine Fläche finden, in welcher der paarweise bestimmte Abstand der Aperturstrahlen minimal wird. Diese Fläche stellt die Eintrittspupille oder eine zu ihr konjugierte Fläche im Ortsraum dar. Insbesondere zeigt diese Fläche eine endliche Krümmung.

Es kann sein, dass die Projektionsoptik 10 unterschiedliche Lagen der Eintrittspupille für den tangentialen und für den sagittalen Strahlengang aufweist. In diesem Fall sollte ein abbildendes Element, insbesondere ein optisches Bauelement der Übertragungsoptik, zwischen dem zweiten Facettenspiegel 22 und dem Retikel 7 bereitgestellt werden. Mit Hilfe dieses optischen Elements kann die unterschiedliche Lage der tangentialen Eintrittspupille und der sagittalen Eintrittspupille berücksichtigt werden.

Bei der in der Fig. 1 dargestellten Anordnung der Komponenten der Beleuchtungsoptik 4 ist der zweite Facettenspiegel 22 in einer zur Eintrittspupille der Projektionsoptik 10 konjugierten Fläche angeordnet. Der erste Facettenspiegel 20 ist verkippt zur Objektebene 6 angeordnet. Der erste Facettenspiegel 20 ist verkippt zu einer Anordnungsebene angeordnet, die vom Umlenkspiegel 19 definiert ist. Der erste Facettenspiegel 20 ist verkippt zu einer Anordnungsebene angeordnet, die vom zweiten Facettenspiegel 22 definiert ist.

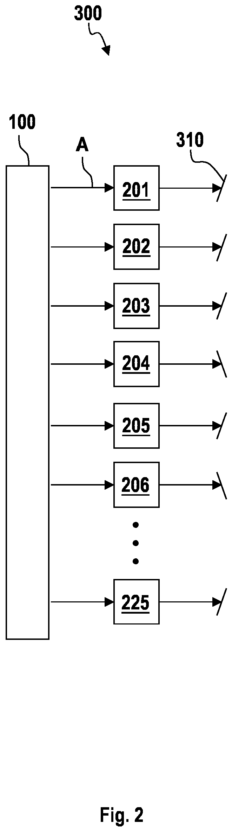

Fig. 2 zeigt eine schematische Darstellung einer Ausführungsform eines opti-schen Systems 300 für eine Lithographieanlage oder Projektionsbelichtungsanlage 1, wie sie beispielsweise in Fig. 1 gezeigt ist. Außerdem kann das optische System 300 der Fig. 2 beispielweise auch in einer DUV-Lithographieanlage eingesetzt werden.

Das optische System 300 der Fig. 2 hat eine Mehrzahl an aktuierbaren optischen Elementen 310. Das optische System 300 ist hier als ein Mikrospiegelarray ausgebildet, wobei die optischen Elemente 310 Mikrospiegel sind. Jeder Mikrospiegel 310 ist mittels eines zugeordneten Aktuators 201-225 aktuierbar. Beispielsweise kann ein jeweiliger Mikrospiegel 310 mittels des zugeordneten Aktuators 201 um zwei Achsen verkippt werden und/oder in einer, zwei oder drei Raumachsen verschoben werden. Aus Gründen der Übersicht sind die Bezugszeichen nur der obersten Reihe dieser Elemente eingezeichnet. In Ausführungsformen kann auch eine Mehrzahl von Aktuatoren 201-225 ein einziges optisches Element 310 aktuieren.

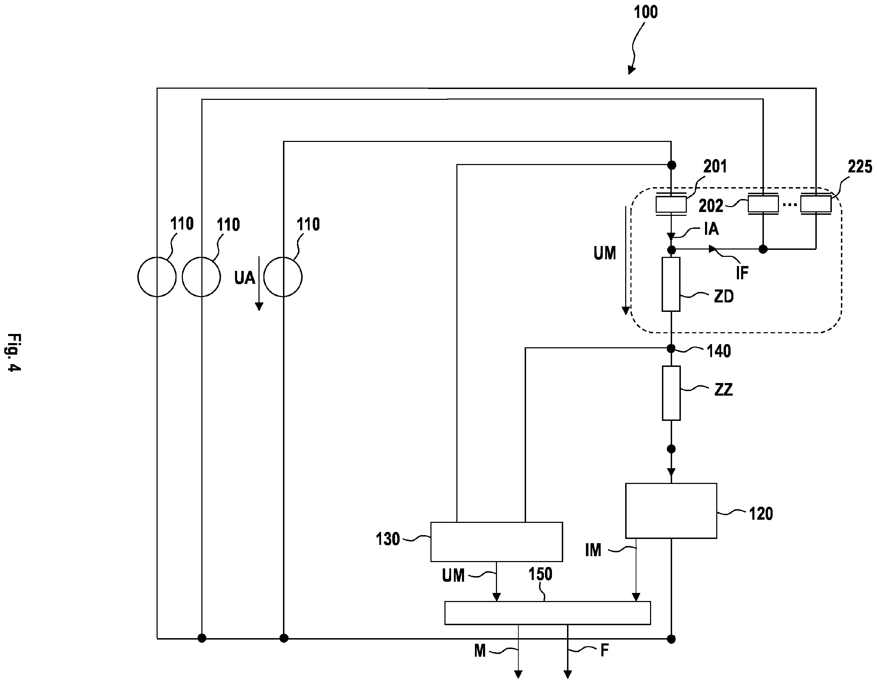

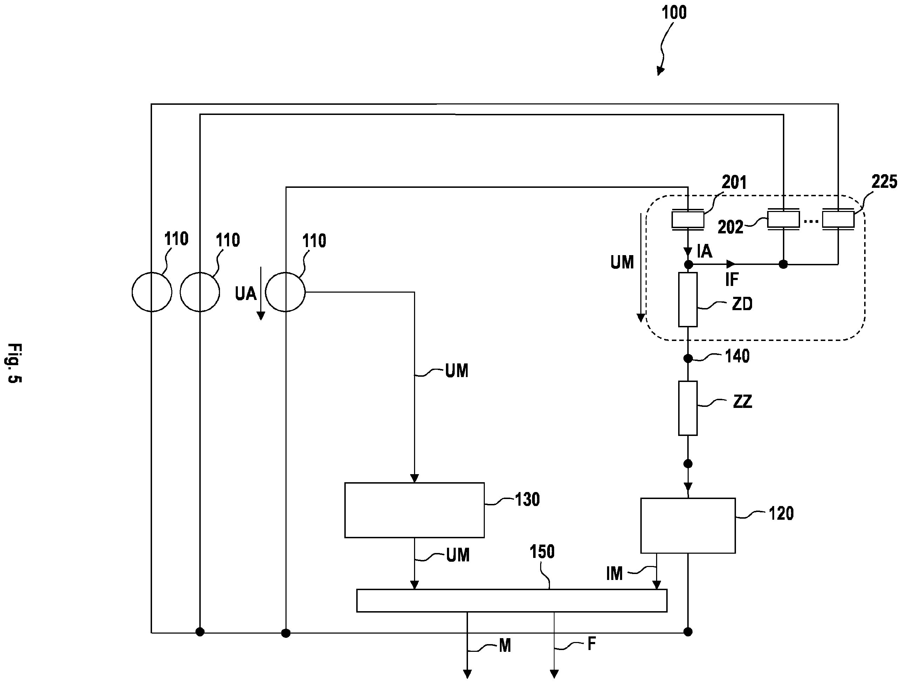

Die Ansteuervorrichtung 100 steuert den jeweiligen Aktuator 201-225 beispielsweise mit einer Ansteuerspannung A an. Damit wird eine Position des jeweiligen Mikrospiegels 310 eingestellt. Die Ansteuervorrichtung 100 ist insbesondere unter Bezugnahme auf die Fig. 4 und 5 beschrieben.

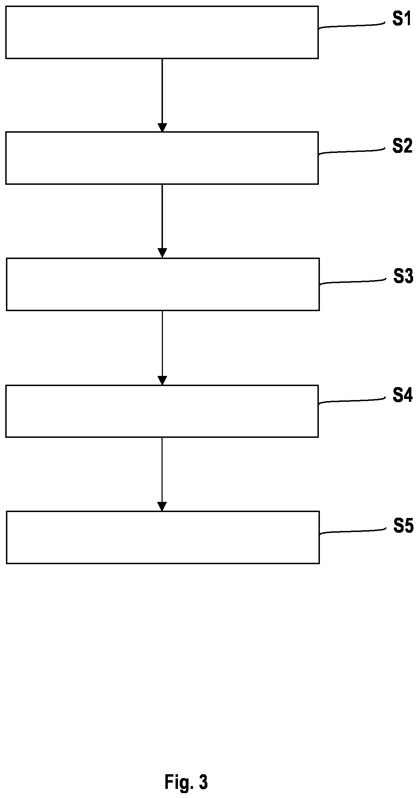

In der Fig. 3 ist eine schematische Ansicht einer Ausführungsform eines Verfahrens zum Ansteuern und zum Vermessen einer Mehrzahl N von Aktuatoren 201-225 zum Aktuieren zumindest eines optischen Elements 310 eines optischen Systems 300 dargestellt. Ohne Einschränkung der Allgemeinheit ist N = 25 in den Fig. 3 bis 6.

Ein Beispiel für ein optisches System 300 ist in Fig. 2 dargestellt. Das optische System 300 ist insbesondere Teil einer Lithographieanlage 1, welche beispielsweise in Fig. 1 dargestellt ist. Das Verfahren gemäß Fig. 3 ist insbesondere durch eine Ansteuervorrichtung 100, wie sie beispielhaft in Fig. 4 oder in Fig. 5 gezeigt ist, ausführbar. Bei dem Verfahren nach Fig. 3 wird während eines bestimmten Vermessungszeitraums ein einzelner zu vermessender Aktuator, in der Fig. 3 der Aktuator 201, der N Aktuatoren 201-225 vermessen.

Das Vermessen des zu vermessenden Aktuators 201 während des Vermessungszeitraums umfasst die Schritte S1-S5 der Fig. 3. Dabei wird das Verfahren der Fig. 3 unter Bezugnahme auf die Fig. 4 erläutert. Hierbei zeigt die Fig. 4 eine erste Ausführungsform einer Ansteuervorrichtung 100 zum Ansteuern und zum Vermessen der N Aktuatoren 201-225 zum Aktuieren zumindest eines optischen Elementes 310 eines optischen Systems 300.

Wie die Fig. 4 zeigt, hat die Ansteuervorrichtung 100 der Fig. 4 eine jeweilige Ansteuereinheit 110 für den jeweiligen Aktuator 201-225, eine Strommesseinheit 120, eine Spannungsmesseinheit 130, eine die N Aktuatoren 201-225 verbindende gemeinsame negative Elektrode 140 sowie eine Steuereinheit 150. Hierbei ist die Steuereinheit 150 dazu eingerichtet, das Vermessen des einzelnen zu vermessenden Aktuators 200 der N Aktuatoren 201-225 während des bestimmten Vermessungszeitraums zu steuern.

Wie oben ausgeführt, ist für den jeweiligen Aktuator 201-225 eine jeweilige Ansteuereinheit 110 vorgesehen. Die Ansteuereinheiten 110 sind durch die Steuereinheit 150 ansteuerbar. Für das vorliegende Beispiel des Vermessens des Aktuators 201 ist die rechte in Fig. 4 dargestellte Ansteuereinheit 110 dazu eingerichtet, den zu vermessenden Aktuator 201 mittels einer Anregungsspannung UA anzuregen. Die Strommesseinheit 120 ist dazu eingerichtet, einen für einen zeitabhängigen Strom IA des mittels der Anregungsspannung UA angeregten Aktuators 201 indikativen Messstrom IM bereitzustellen. Die Spannungsmesseinheit 130 ist dazu eingerichtet, eine für eine zeitabhängige Spannung des mittels der Anregungsspannung UA angeregten Aktuators 210 indikative Messspannung UM bereitzustellen.

Wie die Fig. 4 zeigt, ist die Strommesseinheit 120 zwischen der negativen Elektrode 140 der N Aktuatoren 201-225 und den N Ansteuereinheiten 110 für die N Aktuatoren 201-225 gekoppelt. In der Ausführungsform der Fig. 4 ist die Spannungsmesseinheit 130 zum Bereitstellen der Messspannung UM parallel zu dem zu vermessenden Aktuator 200 geschaltet.

Die Steuereinheit 150 ist dazu eingerichtet zu steuern, dass die N-1 weiteren Aktuatoren, in dem vorliegenden Beispiel die Aktoren 202-225, der N Aktuatoren 201-225 auf einem bestimmten Spannungslevel gehalten werden, während der zu vermessende Aktuator 201 mittels der Anregungsspannung UA angeregt wird. Ferner ist die Steuereinheit 150 dazu eingerichtet, ein Impedanz-Messergebnis M basierend auf dem bereitgestellten Messstrom IM und der bereitgestellten Messspannung UM zu ermitteln und eine für einen Fehler F in der Ansteuervorrichtung 100 indikative Abweichung basierend auf dem ermittelten Impedanz-Messergebnis M zu bestimmen.

Außerdem bezeichnet ZD die Impedanz eines möglichen Defektes in der Ansteuervorrichtung 100 zwischen dem Ausgang der Aktuatoren 201-225 und der gemeinsamen Elektrode 140, und ZZ bezeichnet die Impedanz der Zuleitung, welche die gemeinsame Elektrode 140 mit der Strommesseinheit 120 verbindet. Ferner bezeichnet IF einen Fehlerstrom, der beim Vermessen des Aktuators 201 von dem den zu vermessenden Aktuator 201 und die Impedanz ZD verbindenden Knoten in Richtung der weiteren Aktuatoren 202-205 abfließt.

Zurück zu dem Ablaufdiagramm der Fig. 3 kann das Vermessen des zu vermessenden Aktuators 201 während des Vermessungszeitraums durch die Schritte S1-S5 wie folgt durchgeführt werden:

In dem Schritt S1 wird der zu vermessende Aktuator 201 mittels der von der Ansteuereinheit 110 bereitgestellten Anregungsspannung UA angeregt.

In Schritt S2 wird der für den zeitabhängigen Strom IA des mittels der Anregungsspannung UA angeregten Aktuators 201 indikative Messstrom IM durch die Strommesseinheit 120 bereitgestellt.

In Schritt S3 wird eine für die zeitabhängige Spannung des mittels der Anregungsspannung UA angeregten Aktuators 201 indikative Messspannung UM durch die Spannungsmesseinheit 130 bereitgestellt.

In dem Vermessungszeitraum, und dabei insbesondere während der Durchführung der Schritte S1-S3, werden die N-1 weiteren Aktuatoren 202-225 der N Aktuatoren 201-225 auf einem bestimmten Spannungslevel gehalten. Mit anderen Worten werden die N-1 weiteren Aktuatoren 202-225 auf dem bestimmten Spannungslevel gehalten, zumindest während der zu vermessende Aktuator 201 mittels der Anregungsspannung UA angeregt wird. Der bestimmte Spannungslevel ist beispielsweise eine bestimmte Haltespannung. In diesem Fall werden die N-1 weiteren Aktuatoren 202-225, während der zu vermessende Aktuator 201 mittels der Anregungsspannung UA angeregt wird, auf der bestimmten Haltespannung gehalten. Vorzugsweise sind die bestimmten Haltespannungen der N-1 weiteren Aktuatoren 202-225 identisch.

Das bestimmte Spannungslevel kann in Ausführungsformen auch Masse (auch als Massepotential oder Erde bezeichnet) sein. Dann werden die N-1 weiteren Aktuatoren 202-225, während der zu vermessende Aktuator 201 mittels der Anregungsspannung UA angeregt wird, kurzgeschlossen. Das Vermessen des zu vermessenden Aktuators 201, insbesondere gemäß der Schritte S1-S3, wird vorzugsweise im laufenden Betrieb des optischen Systems 300 durchgeführt.

In Schritt S4 wird ein Impedanz-Messergebnis M basierend auf dem bereitgestellten Messstrom IM und der bereitgestellten Messspannung UM ermittelt.

In Schritt S5 wird eine für einen Fehler F in der Ansteuervorrichtung 100 indikative Abweichung basierend auf dem ermittelten Impedanz-Messergebnis M bestimmt. Wie die Fig. 4 beispielhaft zeigt, kann die Steuereinheit 150 dazu eingerichtet sein, sowohl das Impedanz-Messergebnis M als auch den Fehler F ausgangsseitig, insbesondere zur weiteren Verarbeitung, bereitzustellen.

Eine alternative Ausführungsform der Ansteuervorrichtung 100 ist in Fig. 5 dargestellt. Dabei unterscheidet sich die Ansteuervorrichtung 100 nach Fig. 5 von der Ansteuervorrichtung 100 nach Fig. 4 in der Anordnung der Spannungsmesseinheit 130.

Wie die Fig. 5 zeigt, ist die Spannungsmesseinheit 130 der Fig. 5 mit der dem zu vermessenden Aktuator 201 zugeordneten Ansteuereinheit 110 gekoppelt. Dabei ist die Spannungsmesseinheit 130 dazu eingerichtet, aus der Anregungsspannung UA, welche von der Ansteuereinheit 110 bereitgestellt wird, die Messspannung UM zur Ermittlung des Impedanz-Messergebnisses M abzuleiten.

Des Weiteren zeigt die Fig. 6 ein Kleinsignal-Ersatzschaltbild einer Ausführungsform einer Ansteuervorrichtung 110, wie sie beispielsweise in Fig. 4 oder Fig. 5 dargestellt ist.

In der Fig. 6 bezeichnen UA die Anregungsspannung, UO eine Ausgangsspannung, UD eine Differenzspannung, UM die Messspannung, UF eine Fehlerspannung, ZH eine Impedanz, welche sich aus der Summe von ZD (Impedanz des Defekts) und ZZ (Impedanz der Zuleitung) ergibt (siehe Fig. 4 und 5), ZM die Impedanz des Messwiderstands der Strommesseinheit 120, IA den zeitabhängigen Strom des zu vermessenden Aktuators 201 und VSS Masse (Erdpotenzial).

Wie unter Bezugnahme zu den Fig. 4 und 5 bereits ausgeführt, befindet sich die Strommesseinheit 120 (vgl. ZM in Fig. 6) an der gemeinsamen negativen Elektrode 140 der Aktuatoren 201-225. Da sich alle Aktuatoren 201-225 die negative Elektrode 140 teilen, fließt ein Fehlerstrom IF in die weiteren N-1 Aktuatoren 202-225 und wird von der Messung nicht erfasst. Die Endstufen aller weiteren Aktuatoren 202-225 (dargestellt in Fig. 6 durch: 24x) referenzieren auf VSS.

Das Kleinesignalersatzschaltbild der Fig. 6 basiert auf zwei Annahmen. Erstens ist die Quellenimpedanz bei der Anregungsfrequenz klein genug für eine Kleinsignalbetrachtung, und zweitens ist ZA nahezu gleich in Bezug zu den weiteren 24 Aktuatoren. Damit ergibt sich die Kleinsignalbetrachtung wie folgt:

$$IA = \frac{UM}{ZA} \;;\; IF = \frac{UF}{ZA/24} = \frac{UF \cdot 24}{ZA}$$

$$IA = IM + IF$$

$$\frac{UM}{ZA} = \frac{UF \cdot 24}{ZA} + IM$$

$$UM = UF \cdot 24 + IM \cdot ZA$$

$$UF = IM \cdot ZH$$

$$UM = IM \cdot ZH \cdot 24 + IM \cdot ZA$$

$$\frac{UM}{IM} = ZA + ZH \cdot 24$$

$$ZF = ZH \cdot 24$$

Wie obige Gleichung zeigt, geht bei der Impedanzmessung die Impedanz der Zuleitung 24-fach als Fehler in die Messung ein. Hierdurch ist die Impedanzmessung des zu vermessenden Aktuators 201 in diesem Ausführungsbeispiel um den Faktor 24 sensitiver auf eine Änderung, zum Beispiel der Zuleitungsimpedanz ZH. Die Relation des Faktors 24x sensitiver ergibt sich insbesondere im Vergleich zur herkömmlichen Ansteuervorrichtung nach Fig. 7, bei welcher die N-1 weiteren Aktuatoren 201-225 nicht kontaktiert sind.

Obwohl die vorliegende Erfindung anhand von Ausführungsbeispielen beschrieben wurde, ist sie vielfältig modifizierbar.

BEZUGSZEICHENLISTE

| | |
|---|---|
| 1 | Projektionsbelichtungsanlage |
| 2 | Beleuchtungssystem |
| 3 | Lichtquelle |
| 4 | Beleuchtungsoptik |
| 5 | Objektfeld |
| 6 | Objektebene |
| 7 | Retikel |
| 8 | Retikelhalter |
| 9 | Retikelverlagerungsantrieb |
| 10 | Projektionsoptik |
| 11 | Bildfeld |
| 12 | Bildebene |
| 13 | Wafer |
| 14 | Waferhalter |
| 15 | Waferverlagerungsantrieb |
| 16 | Beleuchtungsstrahlung |
| 17 | Kollektor |
| 18 | Zwischenfokusebene |
| 19 | Umlenkspiegel |
| 20 | erster Facettenspiegel |
| 21 | erste Facette |
| 22 | zweiter Facettenspiegel |
| 23 | zweite Facette |
| 100 | Ansteuervorrichtung |

| | |
|---|---|
| 110 | Ansteuereinheit |
| 120 | Strommesseinheit |
| 130 | Spannungsmesseinheit |
| 140 | negative Elektrode |
| 150 | Steuereinheit |
| 201-225 | Aktuator |
| 300 | optisches System |
| 310 | optisches Element |
| 400 | Ansteuervorrichtung |
| 410 | Ansteuereinheit |
| 420 | Schaltmatrix |
| 430 | Elektrode |

| | |
|---|---|
| A | Ansteuerspannung |
| DU | Differenzspannung |
| F | Fehler |
| IA | zeitabhängiger Strom des zu vermessenden Aktuators |
| IF | Fehlerstrom |
| IM | Messstrom |
| M | Impedanz-Messergebnis |
| M1 | Spiegel |
| M2 | Spiegel |
| M3 | Spiegel |
| M4 | Spiegel |
| M5 | Spiegel |
| M6 | Spiegel |
| S1 | Verfahrensschritt |
| S2 | Verfahrensschritt |
| S3 | Verfahrensschritt |
| S4 | Verfahrensschritt |
| S5 | Verfahrensschritt |
| UF | Fehlerspannung |
| UO | Ausgangsspannung |
| UM | Messspannung |
| VSS | Masse |
| ZA | Impedanz des zu vermessenden Aktuators |
| ZD | Impedanz eines Defektes in der Ansteuervorrichtung |
| ZH | Impedanz aus der Summe von ZD und ZZ |
| ZM | Impedanz des Messwiderstands |
| ZZ | Impedanz der Zuleitung |

**Patentansprüche**

1. Verfahren zum Betreiben einer Ansteuervorrichtung (100) zum Ansteuern und zum Vermessen einer Mehrzahl N von Aktuatoren (201-225) zum Aktuieren zumindest eines optischen Elements (310) eines optischen Systems (300), wobei während eines bestimmten Vermessungszeitraums ein einzelner zu vermessender Aktuator (201) der N Aktuatoren (201-225) vermessen wird, in dem der zu vermessende Aktuator (201) mittels einer von einer Ansteuereinheit (110) bereitgestellten Anregungsspannung (UA) angeregt wird (S1), ein für einen zeitabhängigen Strom (IA) des mittels der Anregungsspannung (UA) angeregten Aktuators (201) indikativer Messstrom (IM) durch eine Strommesseinheit (120) bereitgestellt wird (S2), eine für eine zeitabhängige Spannung des mittels der Anregungsspannung (UA) angeregten Aktuators (201) indikative Messspannung (UM) durch eine Spannungsmesseinheit (130) bereitgestellt wird (S3), ein Impedanz-Messergebnis (M) basierend auf dem bereitgestellten Messstrom (IM) und der bereitgestellten Messspannung (UM) ermittelt wird (S4) und eine für einen Fehler (F) in der Ansteuervorrichtung (100) indikative Abweichung basierend auf dem ermittelten Impedanz-Messergebnis (M) bestimmt wird (S5), wobei die N-1 weiteren Aktuatoren (202-225) der N Aktuatoren (201-225) auf einem bestimmten Spannungslevel gehalten werden, während der zu vermessende Aktuator (201) mittels der Anregungsspannung (UA) angeregt wird.

2. Verfahren nach Anspruch 1,
   wobei das Vermessen des zu vermessenden Aktuators (201) im laufenden Betrieb des optischen Systems (300) durchgeführt wird.

3. Verfahren nach Anspruch 1 oder 2,
   wobei die N-1 weiteren Aktuatoren (202-225), während der zu vermessende Aktuator (201) mittels der Anregungsspannung (UA) angeregt wird, auf einer bestimmten Haltespannung gehalten werden.

4. Verfahren nach Anspruch 3,
   wobei die bestimmten Haltespannungen der N-1 weiteren Aktuatoren (202-225) identisch sind.

5. Verfahren nach Anspruch 1 oder 2,
   wobei die N-1 weiteren Aktuatoren (202-225), während der zu vermessende Aktuator (201) mittels der Anregungsspannung (UA) angeregt wird, kurzgeschlossen werden.

6. Verfahren nach einem der Ansprüche 1 bis 5,
   wobei die N Aktuatoren (201-225) an einer gemeinsamen negativen Elektrode (140) verbunden sind.

7. Verfahren nach Anspruch 6,
   wobei die Strommesseinheit (120) zum Bereitstellen des Messstroms (IM), welcher indikativ für den zeitabhängigen Strom (IA) des mittels der Anregungsspannung (UA) angeregten Aktuators (201) ist, zwischen der negativen Elektrode (140) der N Aktuatoren (201-225) und den N Ansteuereinheiten (110) für die N Aktuatoren (201-225) gekoppelt wird.

8. Verfahren nach einem der Ansprüche 1 bis 7,
   wobei die Spannungsmesseinheit (130) zum Bereitstellen der Messspannung (UM) parallel zu dem zu vermessenden Aktuator (201) geschaltet wird.

9. Verfahren nach einem der Ansprüche 1 bis 7,
   wobei die Spannungsmesseinheit (130) zum Bereitstellen der Messspannung (UM) mit der dem zu vermessenden Aktuator (201) zugeordneten Ansteuereinheit (110) gekoppelt wird.

10. Verfahren nach einem der Ansprüche 1 bis 9,
    wobei die N Aktuatoren (201-225) und die gemeinsame negativen Elektrode (140) als Teil einer Aktuatormatte ausgebildet sind.

11. Ansteuervorrichtung (100) zum Ansteuern und zum Vermessen einer Mehrzahl N von Aktuatoren (201-225) zum Aktuieren zumindest eines optischen Elements (310) eines optischen Systems (300), mit:

    einer Steuereinheit (150), welche dazu eingerichtet ist, ein Vermessen eines einzelnen zu vermessenden Aktuators (201) der N Aktuatoren (201-225) während eines bestimmten Vermessungszeitraums zu steuern,
    einer von der Steuereinheit (150) gesteuerten Ansteuereinheit (110), welche dazu eingerichtet ist, den zu vermessenden Aktuator (201) mittels einer Anregungsspannung (UA) anzuregen,
    einer Strommesseinheit (120) zum Bereitstellen eines für einen zeitabhängigen Strom (IA) des mittels der Anregungsspannung (UA) angeregten Aktuators (201) indikativen Messstroms (IM), und
    einer Spannungsmesseinheit (130) zum Bereitstellen einer für eine zeitabhängige Spannung des mittels der Anregungsspannung (UA) angeregten Aktuators (201) indikativen Messspannung (UM),
    wobei die Steuereinheit (150) dazu eingerichtet ist zu steuern, dass die N-1 weiteren Aktuatoren (202-225) der N Aktuatoren (201-225) auf einem bestimmten Spannungslevel gehalten werden, während der zu vermessende Aktuator (201) mittels der Anregungsspannung (UA) angeregt wird, wobei die Steuereinheit (150) ferner dazu eingerichtet ist, ein Impedanz-Messergebnis (M) basierend auf dem bereitgestellten Messstrom (IM) und der bereitgestellten Messspannung (UM) zu ermitteln und eine für einen Fehler (F) in der Ansteuervorrichtung (100) indikative Abweichung basierend auf dem ermittelten Impedanz-Messergebnis (M) zu bestimmen.

12. Ansteuervorrichtung nach Anspruch 11,
    wobei die N Aktuatoren (201-225) an einer gemeinsamen negativen Elektrode (140) verbunden sind.

13. Optisches System (300) mit einer Anzahl an aktuierbaren optischen Elementen (310), wobei jedem der aktuierbaren optischen Elemente (310) eine Anzahl an Aktuatoren (201-225) zugeordnet ist, welchen eine Ansteuervorrichtung (100) zum Ansteuern der Aktuatoren (201-225) gemäß einem der Ansprüche 1 bis 12 zugeordnet ist.

14. Optisches System nach Anspruch 13, wobei das optische System (300) als eine Beleuchtungsoptik (4) oder als eine Projektionsoptik (10) einer Lithographieanlage (1) ausgebildet ist.

15. Lithographieanlage (1) mit einem optischen System (300) nach Anspruch 13 oder 14.

Fig. 1

EP 4 530 720 A2

300

100

A

310

201

202

203

204

205

206

225

Fig. 2

Fig. 3

**Fig. 4**

**Fig. 5**

Fig. 6

400

420

225

410

201  202

ZD

430

ZF

Fig. 7 (Stand der Technik)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102023209509
- DE 102008009600 A1
- US 20060132747 A1
- EP 1614008 B1
- US 6573978 B
- DE 102017220586 A1
- US 20180074303 A1